# EUROPEAN PATENT SPECIFICATION

(11) **EP 0 317 445 B1**
(45) Date of publication and mention of the grant of the patent: **01.05.1996**
(21) Application number: 88402910.9
(22) Date of filing: 18.11.1988
(51) Int. Cl.: H01L 21/36

(54) **Method for fabricating a silicon carbide substrate**
Verfahren zur Herstellung eines Siliciumcarbidsubstrats
Méthode pour fabriquer un substrat en carbure en carbure de silicium

(30) Priority: 20.11.1987 JP 294617/87
(43) Date of publication of application: 24.05.1989
(73) Proprietor: FUJITSU LIMITED, Kawasaki-shi, Kanagawa 211 (JP)
(72) Inventor: Gotou, Hiroshi, Niiza-shi Saitama 352 (JP)
(74) Representative: Joly, Jean-Jacques

(56) References cited:
- FR-A- 2 027 429
- GB-A- 2 206 445
- IEEE ELECTRON DEVICE LETTERS, Vol. EDL-7, No. 12, 1986, pp. 692-693.
- INTERNATIONAL ELECTRON DEVICES MEETING, Washington, US, December 1-4, 1985, Technical Digest, pp. 684-687 ; J.B. LASKY et al. : "Silicon-on-insulator (SOI) by bonding and etch-back"
- JOURNAL OF THE ELECTROCHEMICAL SOC., vol. 133, no. 8, August 1986, pp. 1673-1677, New York, US ; R.C. FRYE et al. : "A field-assisted bonding process for silicon dielectric isolation"
- EXTENDED ABSTRACTS FALL MEETING, vol. 87-2, Honolulu, October 18-23, 1987, page 997, abstract no. 700 ; Electrochem. Soc., Princeton, US ; B. MOLNAR et al. : "High resistivity polysilicon as a supporting and isolating substrate for thin, cubic beta-silicon carbide films"

## Description

### BACKGROUND OF THE INVENTION

The present invention relates to a method for fabricating a silicon carbide substrate, especially to form a beta silicon carbide layer on an insulator.

Silicon carbide (SiC) is known as a semiconductor material which has a wide band gap in its energy level compared to that of silicon, and is suitable for fabricating devices which can be used at high temperature. In particular beta silicon carbide (β-SiC) is known to be desirable for fabricating various active devices, such as transistors or field effect transistors (FETs). Details of such devices can be found, for example, in "Experimental 3C-SiC MOSFET" by Y. Kondo et al. IEEE ED Letters Vol. EDL-7. N°. 7, July 1986.

But single crystals of β-SiC usable for fabricating active devices such as transistors or FETs are still not available by the present state-of-the-art semiconductor technology. These devices are fabricated using epitaxially grown silicon carbide layers. It is considered that a better epitaxial layer of SiC may be obtained using a SiC substrate, but since a SiC substrate large enough for fabricating various devices is not available, the growth of a SiC layer is usually accomplished using a silicon substrate. Therefore, silicon substrate is presently considered to be the only practical semiconductor substrate on which β-SiC can be epitaxially grown. Such growth of crystal is called hetero-epitaxial growth, because the crystal of the substrate and the grown crystal are different from each other.

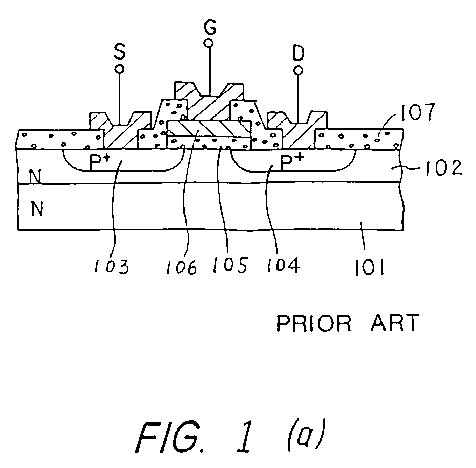

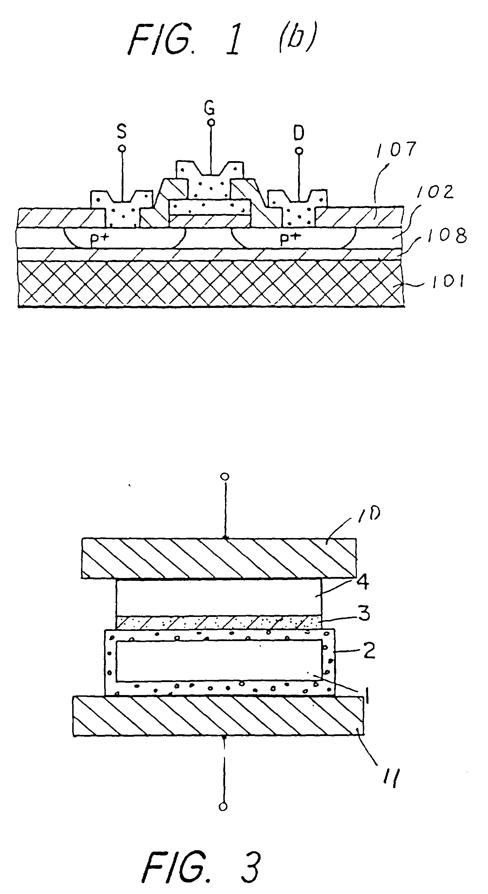

A typical structure of a FET formed in a SiC epitaxial layer is shown in Fig. 1(a), where 101 designates a silicon substrate, and 102a is a hetero-epitaxially grown β-SiC layer. In this example, both the silicon substrate and the SiC layer are of n-type conductivity. A source region 103 and a drain region 104 are fabricated by doping p⁺ type impurities. A gate oxide layer 105 composed of silicon dioxide (SiO₂) is formed over the channel region, and a gate electrode 106 is formed over layer 105. The surface of the device is coated with a silicon dioxide layer 107. Electrodes indicated by G, S and D contact respectively the gate, source and drain regions through contact holes formed in the SiO₂ layer 107.

In such a FET structure, it has been found that the leakage current is relatively large. This is considered to be mainly due to the fact that the SiC epitaxial layer 102 formed on the silicon substrate 101 is poor in quality, whereby the pn junction formed in such SiC layer is likely to become a leaky junction, and that the conductivity of the silicon substrate 101 becomes higher than that of the SiC layer 102 at the high temperature at which the SiC devices are expected to operate (500 - 600 °C for example). Therefore, a FET such as illustrated by Fig. 1(a) can hardly be used at high temperatures. Such defects occur in a similar way with other types of devices made from SiC material.

To avoid such defects of SiC devices, it has been suggested to insert an additional layer between the SiC layer and the Si substrate in order to suppress the leakage current through the silicon substrate. For example, in "Fabrication of Inversion-Type n-Channel MOSFET's Using Cubic-SiC on Si(100)" by K. Shibahara et al., IEEE ELECTRON DEVICE LETTERS, Vol. EDL-7, NO. 12, December 1986, or "Insulated-Gate and Junction-Gate FET's of CVD-Grown β -SiC" by K. Furukawa et al. IEEE ED Letters, Vol. EDL-8, N°.2, Feb. 1987, it has been proposed to insert a further SiC layer of another conductivity type so as to form a pn junction with the former SiC layer. This pn junction prevents current leakage.

In silicon devices, SOI (semiconductor on insulator) structures are known in which a silicon crystal is grown on an insulator such as a silicon dioxide layer formed on a silicon substrate.

If it were possible to grow a β -SiC crystal on an insulator this could be effective for preventing current leakage through the substrate. A fundamental configuration is shown in Fig. 1(b). The same reference numerals designate same parts in Figs. 1(a) and 1(b). Compared to Fig. 1(a), the proposed new device of Fig. 1(b) includes a silicon dioxide layer 108 between the silicon substrate 101 and the SiC layer 102. By inclusion of this silicon dioxide layer 108, the current leakage of the SiC FET is greatly reduced, because the current leakage through the silicon substrate 101 is suppressed.

The problem remains however as to how to realize such a SOI type device formed with SiC, that is, a device with a substrate having a structure of SiC on insulator. One proposal could consist in using a β -SiC crystal as the insulating substrate. The resistivity of undoped β -SiC is very high, but large size perfect crystals of β -SiC are still not available, the size of the substrate being an important factor for fabricating various semiconductor devices.

### SUMMARY OF THE INVENTION

The object of the present invention is, therefore, to provide a method which enables the fabrication of a semiconductor substrate having a β -SiC epitaxial layer grown on an insulator, that is to say an SOI structure (the semiconductor being SiC).

Another object of the present invention is to provide a large size β -SiC substrate, on which various semiconductor devices can be fabricated.

Still another object of the present invention is to reduce leakage current of devices fabricated in a silicon carbide layer.

The present invention utilizes an SiO₂ layer as the insulation layer between the SiC and the substrates, and the processing steps defined in claim 1.

These and other modifications and advantages of the present invention will become apparent in the following detailed description of the preferred embodiment and accompanying drawings.

For further information on wafer bonding techniques, reference may be made to International Electron Devices Meeting, Washington, December 1985, Technical Digest, pp. 684-687, US. in which is described a silicon-on-insulator device obtained by bonding thermally-grown oxide layers on respective wafers.

A description of a field-assisted technique for bonding oxidized to unoxidized wafers as well as oxidized to oxidized wafers is also described in a more general context, in the Journal of the Electrochemical Soc., vol. 133, no. 8, August 1986, pp. 1673-1677, New York, US.

### BRIEF DESCRIPTION OF THE DRAWINGS

Fig. 1(a) is a schematic cross sectional view of a typical FET formed in a silicon carbide substrate.
Fig. 1(b) is a schematic cross sectional view of a proposed structure of a FET improved in that the current leakage is lower than that of the FET of Fig. 1(a).
Figs. 2(a) to 2(d) are schematic cross sectional views of a substrate illustrating a fundamental process according to the present invention for fabricating a SiC-on-insulator-on-semiconductor structure, wherein :

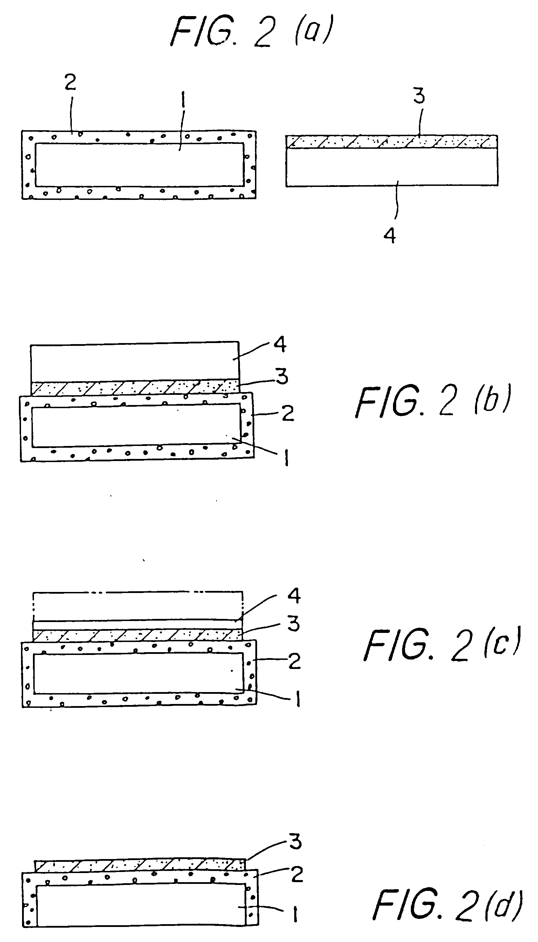

Fig.2(a) shows a first and a second substrate prepared for carrying out the process ;
Fig 2(b) shows the step in which the two substrates are stacked ;
Fig. 2(c) illustrates the step in which the second substrate is polished or etched from the back side of the stack ; and
Fig.2(d) illustrates the final step in which the substrate has a SiC-on-SiO₂-on-semiconductor structure.
Fig. 3 illustrates how an electrostatic potential is applied to the stacked substrates.

### DESCRIPTION OF THE PREFERRED EMBOOIMENTS

It is known that silicon carbide has two types of crystal structure, α and β -type crystals. The β -type crystal is much more desirable for fabricating active devices such as transistors or FETs. In the following description, if not specially identified, the words silicon carbide, or SiC refer only to the β -type silicon carbide (β -SiC).

It is known in the art that silicon substrates can be bonded to one another by insertion of a silicon dioxide layer between the two substrates and subsequent treatment at high temperature. Details of such technology are disclosed in, for example, "SILICON-ON-INSULATOR (SOI) BY BONDING AND ETCH-BACK" by J. B. Lasky et al. IEDM 85, 1985 IEEE, or "Study of Si-Wafer Directly Bonded Interface Effect on Power Device Characteristics" by H. Ohasi et al. IEDM 87, 1987 IEEE. But bonding technology applicable for SiC substrate is as yet unknown. The inventor discovered that a SiC layer can be bonded on a SiO₂ layer by proper thermal treatment. Applying this discovery it has become possible to provide a substrate having a SiC-I-Si structure.

Figs. 2(a) to 2(d) illustrate a fundamental process for fabricating a SiC-SiO₂-Si substrate, that is a SiC-on-SiO₂ layer formed on a Si substrate, by bonding two kinds of substrates. These figures schematically illustrate how the cross sections of the substrates vary at each step of the fabrication process.

First, as shown in Fig. 2(a), two kinds of substrates 1 and 4 are prepared. The first substrate 1 may typically be an n type silicon substrate of about 600 µm thick. The surface of the first substrate 1 is coated with a SiO₂ layer 2 of 0.5 - 1 µm thick. This SiO₂ layer is formed by chemical vapor deposition (CVD) or thermal oxidation. The second substrate 4 is an n type single silicon crystal typically of about 600 µm thick. On one side of the second substrate 4 is grown an n type SiC crystal 3 typically of about 0.5 µm thick.

The growth technology of the SiC layer 3 is known in the art as a hetero-epitaxial growth. In accordance with this technology, the surface of the second substrate 4 is carbonized by heating the substrate at about 1,300 °C in a flow of propane gas (C₃H₈). The gas is then switched to a propane and silane gas (SiH₄) mixture, and the temperature is regulated at 1100 -1200 °C. By this process, a SiC single crystal is epitaxially grown on the surface of the substrate 4. Further detail can be seen in for example, "Fabrication of Inversion-Type n-Channel MOSFETs Using Cubic-SiC on Si(100)" by K. Shibahara et al. IEEE ELECTRON DEVICE LETTERS, Vol. EDL-7, N°. 12, December 1986.

The first and second substrates are stacked together as shown in Fig. 2(b), and thermally treated at 600 °C for 10 min. in an inert gas ambient such as nitrogen at 0.1 Pa pressure. This process is called first thermal treatment. Then the temperature is further raised to 1100 °C and the stack is annealed for about 30 min. This process is called second thermal treatment. By these thermal treatments, the two substrates 1 and 4 are bonded to one another.

During the thermal treatment, it is desirable to place a weight on the stacked substrates to correct any slight curvature which might have been present in the substrates, and to prevent creation of voids in the bonding surface. For this purpose, a weight made of a carbon graphite plate of about 1cm thick is effective.

To prevent the creation of voids, it is also effective to apply a technique known in the art as anodic bonding. Details of this technique can be seen in "A Field-Assisted Bonding Process for Silicon Dielectric Isolation" by R. C. Frye et al., Jour. Electrochem. Soc. Vol. 133, N°. 8 August 1986. This literature discloses a technology for bonding a silicon substrate on silicon. The inventor applied the anodic bonding technique for bonding SiC on SiO₂ coated silicon, and found that it is effective in realizing a void-free bond.

According to this technique, electrical potential is applied between the first and second substrates during the first thermal treatment. The adhesion of the substrates is independent of the polarity of the electric field. The SiC layer 3 and the Si substrate 4 may be said to act as a capacitor separated by the SiO₂ layer 2. The electrostatic force which attracts the SiC layer 3 toward the second substrate 1 becomes very strong due to the thinness of the electrode (about 1 µm). The need for the application of a weight is thus eliminated.

Fig. 3 shows how the electric voltage is applied between the first substrate 1 and the second substrate 4. The upper electrode 10 and the lower electrode 11 are made of carbon graphite plate of about 1 cm thick. Because the attractive force increases with an increase in the voltage applied between the electrodes, the higher the applied voltage, the better the result until electric breakdown occurs. In one realization, a static voltage of 200 V was applied between the upper and lower electrodes 10 and 11. The carbon graphite electrode placed on the substrate also served as a weight to eliminate curvature of the substrates and aided in the prevention of voids between the bonded surfaces.

Further, it has been found that an application of pulse voltage is preferable to the application of static voltage. This is also a known technique in the art of bonding silicon substrates. Details can be seen for example in "SOI Substrate by Bonding Technology" (written in Japanese) by Arimoto et al., Publication 30a-B-1 from 1987 Spring Convention of Japan Society of Applied Physics, March 1987. In an embodiment, pulse voltage of 500 V, 100 ms duration was applied with a repetition period of 500 ms during the first thermal treatment. By applying such technique, it became possible to obtain a void free substrate of large dimension, four inches in diameter for example.

Turning back to Fig. 2(c), after the bonding is completed, the silicon layer 4 of the first substrate is removed by mechanical polishing or chemical etching to expose the SiC layer 3 as shown in Fig. 2(d). In this removal process, it is important to take care not to remove the SiC layer 3. However, the process of removal of the Si layer 4 is facilitated by the fact that β -SiC is harder than Si, and by the fact that SiC is not removed by the etchant for Si (mixture of hydrofluoric acid and chloric acid for example). Consequently, over-polishing or over-etching can be easily avoided.

According to the aforegoing process, large-size substrates having a SiC-SiO₂-Si structure can be obtained. The ability to manufacture large-size substrate is an important factor for the fabrication of semiconductor devices at low cost. The above fundamental process can be modified in various ways. Some of these variations will now be described.

As has been described, the present invention permits the realization of an SOI structure using β-SiC. Several variations of the invention may be possible. For example, the etching of the second substrate 4 may be replaced by reactive ion etching (RIE).

## Claims

1. A method of fabricating a semiconductor substrate having a semiconductor (3) on insulator (2) structure, said semiconductor being beta type silicon carbide (β-SiC), said method comprising the following steps :
a) preparing a first substrate (1) made of a first semiconductor material, and a second substrate (4) made of silicon single crystal;
b) forming a layer of beta type silicon carbide (β-SiC) single crystal (3) on one surface of said second substrate (4),
c) coating the surface of said first substrate with a silicon dioxide layer (2);
d) stacking said semiconductor substrate (4) having said layer of beta type silicon carbide (β-SiC) single crystal (3) onto said first substrate (1) having said silicon dioxide layer (2) such that said layer of beta type silicon carbide (β-SiC) single crystal (3) and silicon dioxide of said silicon dioxide layer (2) are in contact;
e) bonding the stacked first substrate (1) having said silicon dioxide layer (2) and said semiconductor substrate (4) having said layer of beta type silicon carbide (β-SiC) single crystal (3) by heating them in an inert gas ambient; and
f) removing said second substrate (4) to expose said layer of beta type silicon carbide (β-SiC) single crystal (3).

2. A method for fabricating a semiconductor substrate as set forth in claim 1, wherein said inert gas ambient is nitrogen.

3. A method for fabricating a semiconductor substrate as set forth in claim 1, wherein said bonding step (c) further comprises a substep of applying electric potential between said first substrate (1) and said silicon dioxide layer (2) and said second substrate (4) and said silicon dioxide layer (2).

4. A method for fabricating a semiconductor substrate as set forth in claim 1, wherein said first semiconductor material is silicon or silicon carbide.

## Patentansprüche

1. Ein Verfahren zum Herstellen eines Halbleitersubstrats, das eine Halbleiter(3)-auf-Isolator(2)-Struktur hat, welcher Halbleiter ein Beta-Typ-Siliziumcarbid (β-SiC) ist, welches Verfahren die folgenden Schritte umfaßt:
a) Vorbereiten eines ersten Substrats (1) aus einem ersten Halbleitermaterial und eines zweiten Substrats (4) aus Siliziumeinkristall;
b) Bilden einer Schicht aus Beta-Typ-Siliziumcarbid-(β-SiC)-Einkristall (3) auf einer Oberfläche des genannten zweiten Substrats (4),
c) Beschichten der Oberfläche des genannten ersten Substrats mit einer Siliziumdioxidschicht (2);
d) Stapeln des genannten Halbleitersubstrats (4), das die genannte Schicht aus Beta-Typ-Siliziumcarbid-(β-SiC)-Einkristall (3) hat, auf das genannte erste Substrat (1), das die genannte Siliziumdioxidschicht (2) hat, so daß die genannte Schicht aus Beta-Typ-Siliziumcarbid-(β-SiC)-Einkristall (3) und das Siliziumdioxid der genannten Siliziumdioxidschicht (2) in Kontakt sind;
e) Bonden des gestapelten ersten Substrats (1), das die genannte Siliziumdioxidschicht (2) hat, und genannten Halbleitersubstrats (4), das die genannte Schicht aus Beta-Typ-Siliziumcarbid-(β-SiC)-Einkristall (3) hat, durch deren Erhitzen in einer Inertgasumgebung; und
f) Entfernen des genannten zweiten Substrats (4), um die genannte Schicht aus Beta-Typ-Siliziumcarbid-(β-SiC)-Einkristall (3) zu exponieren.

2. Ein Verfahren zum Herstellen eines Halbleitersubstrats nach Anspruch 1, bei dem die genannte Inertgasumgebung Stickstoff ist.

3. Ein Verfahren zum Herstellen eines Halbleitersubstrats nach Anspruch 1, bei dem der genannte Bondschritt (e) ferner einen Unterschritt zum Anwenden von elektrischem Potential zwischen dem genannten ersten Substrat (1) und der genannten Siliziumdioxidschicht (2) und dem genannten zweiten Substrat (4) und der genannten Siliziumdioxidschicht (2) umfaßt.

4. Ein Verfahren zum Herstellen eines Halbleitersubstrats nach Anspruch 1, bei dem das genannte erste Halbleitermaterial Silizium oder Siliziumcarbid ist.

## Revendications

1. Procédé de fabrication d'un substrat semiconducteur comportant un semiconducteur (3) sur une structure isolante (2), ledit semiconducteur étant du carbure de silicium du type béta (β-SiC), ledit procédé comprenant les étapes suivantes :
a) préparation d'un premier substrat (1) en un premier matériau semiconducteur et d'un second substrat (4) en silicium monocristallin ;
b) formation d'une couche de monocristal de carbure de silicium de type béta (β-SiC) (3) sur une surface dudit second substrat (4) ;
c) revêtement de la surface dudit premier substrat par une couche de dioxyde de silicium (2) ;
d) empilement dudit substrat semiconducteur (4) comportant ladite couche de monocristal de carbure de silicium de type béta (βSiC) (3) sur ledit premier substrat (1) comportant ladite couche de dioxyde de silicium (2) de telle sorte que ladite couche de monocristal de carbure de silicium de type béta (βSiC) (3) et le dioxyde de silicium de ladite couche de dioxyde de silicium (2) soient en contact ;
e) liaison du premier substrat empilé (1) comportant ladite couche de dioxyde de silicium (2) et dudit substrat semiconducteur (4) comportant ladite couche de monocristal de carbure de silicium de type béta (βSiC) (3) en les chauffant dans une atmosphère de gaz inerte ; et
f) enlèvement dudit second substrat (4) afin de mettre à nu ladite couche de monocristal de carbure de silicium de type béta (β-SiC) (3).

2. Procédé de fabrication d'un substrat semiconducteur selon la revendication 1, dans lequel ladite atmosphère de gaz inerte est de l'azote

3. Procédé de fabrication d'un substrat semiconducteur selon la revendication 1, dans lequel ladite étape de liaison (e) comprend en outre une sous-étape d'application d'un potentiel électrique entre ledit premier substrat (1) et ladite couche de dioxyde de silicium (2) ainsi qu'entre ledit second substrat (4) et ladite couche de dioxyde de silicium (2).

4. Procédé de fabrication d'un substrat semiconducteur selon la revendication 1, dans lequel ledit premier matériau semiconducteur est du silicium ou du carbure de silicium.
